# DEMANDE DE BREVET EUROPEEN

(11) **EP 4 336 569 A1**
(43) Date de publication de la demande: **13.03.2024**
(21) Numéro de dépôt: 23195629.3
(22) Date de dépôt: 06.09.2023
(51) Int. Cl.: H01L 31/0216, H01L 31/0224, H01L 31/0747, H01L 31/18

(54) **CELLULE PHOTOVOLTAIQUE A CONTACTS PASSIVES EN DOUBLE FACE ET COMPORTANT DES PORTIONS D'OTC LOCALISÉES SOUS LES MÉTALLISATIONS AVANT**

(30) Priorité: 09.09.2022 FR 2209080
(71) Demandeur: Commissariat à l'Énergie Atomique et aux Énergies Alternatives, 75015 Paris (FR); Centre National de la Recherche Scientifique, 75794 Paris Cedex 16 (FR); Université Savoie Mont Blanc, 73011 Chambéry Cedex (FR); UNIVERSITÉ GRENOBLE ALPES, 38400 Saint-Martin-d'Heres (FR); Institut Polytechnique de Grenoble, 38031 Grenoble Cedex 1 (FR)
(72) Inventeur: SERON, Charles, 73000 CHAMBERY (FR); GRANGE, Bernadette, 38054 GRENOBLE CEDEX 09 (FR)
(74) Mandataire: Brevalex

(57) **Abrégé**

Cellule photovoltaïque (100) comportant :
- un substrat (102) cristallin ;
- des première et deuxième couches de passivation (108, 110) disposée respectivement contre des première et deuxième faces du substrat ;
- une première couche sélective de charge (112) dopée selon le même type de conductivité que le substrat et disposée contre la première couche de passivation, et une deuxième couche sélective de charge (114) dopée selon un autre type de conductivité et disposée contre la deuxième couche de passivation ;
- une première couche d'oxyde d'indium (116) disposée entre des contacts électriques (118) arrière et la deuxième couche sélective de charge ;
-des premières portions (120) d'oxyde transparent conducteur comportant du zinc, disposées entre des contacts électriques (122) avant et des premières régions (124) de la première couche sélective de charge.

## Description

### DOMAINE TECHNIQUE

L'invention concerne le domaine des cellules photovoltaïques à contacts passivés en double face, ainsi que la réalisation de telles cellules.

### ÉTAT DE LA TECHNIQUE ANTÉRIEURE

Les cellules photovoltaïques à contacts passivés intégrés en double face ont l'avantage d'avoir des faces avant et arrière totalement passivées, ce qui augmente de manière significative leurs performances. Dans de telles cellules, des couches sélectives de charge dopées, polycristallines ou amorphes, de faible épaisseur, par exemple inférieure à 30 nm, sont généralement utilisées afin de limiter l'absorption optique parasite dans ces couches. En outre, le dépôt par pulvérisation cathodique (« DC-sputtering » en anglais) d'une couche d'oxyde transparent conducteur, ou OTC, en double face, afin de contacter la couche active sélective de charges, rendue fortement résistive du fait de la diminution de son épaisseur, est généralement nécessaire.

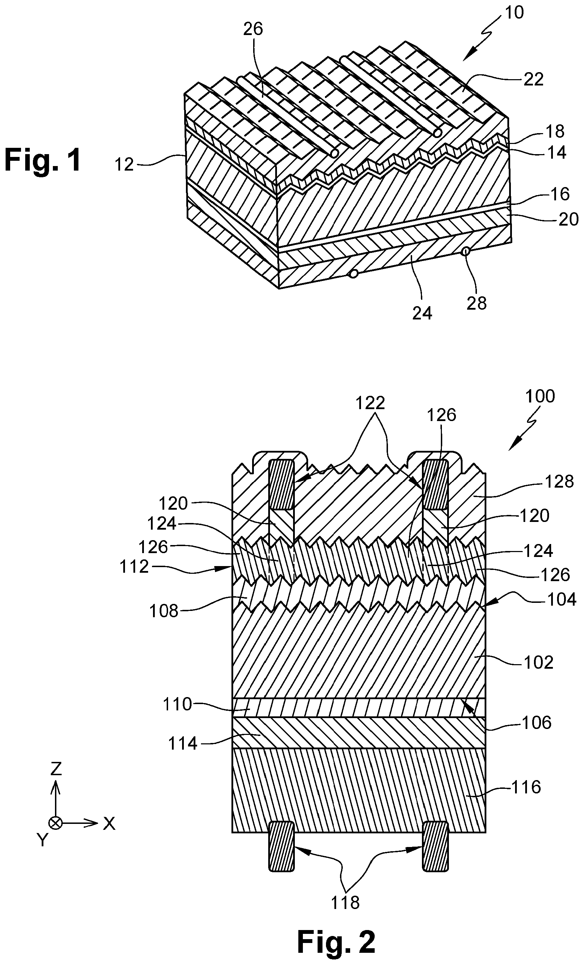

La figure 1 représente un exemple d'une cellule photovoltaïque 10 à contacts passivés en double face.

La cellule 10 est réalisée à partir d'un substrat 12 de semi-conducteur cristallin, ici du silicium de type n. La face avant du substrat 12, destinée à se trouver du côté de la face avant de la cellule 10, est structurée de manière à former des motifs antireflets au niveau de la face avant de la cellule 10.

Une croissance d'une couche de passivation (par exemple à base d'oxyde de silicium SiOx ou de silicium amorphe intrinsèque hydrogéné a-Si:H(i)) est réalisée par croissance du côté des faces avant et arrière du substrat 12, formant des couches de passivation référencées 14 et 16 sur la figure 1.

Des couches 18 et 20 sélectives de charges dopées, respectivement n et p, sont ensuite réalisées sur les couches de passivation 14, 16. Ces couches 18 et 20 correspondent typiquement à des couches de poly-silicium ou des couches de silicium amorphe hydrogéné.

Des couches d'OTC 22, 24 sont ensuite déposées sur les couches 18, 20.

Des métallisations 26, 28, comprenant par exemple de l'argent, sont ensuite réalisées par sérigraphie sur les couches d'OTC 22, 24.

Les couches d'OTC comportent généralement des matériaux à base d'indium qui présentent d'excellentes propriétés électriques et optiques : oxyde d'indium hydrogéné (IO:H), oxyde d'indium dopé à l'étain, hydrogéné ou non (ITO:H ou ITO), etc. Cependant, les ressources limitées en indium et son coût élevé sont des points bloquants pour l'industrialisation des technologies à contacts passivés.

Sur l'exemple de la figure 1, la cellule 10 est dans une configuration dite « à émetteur inversé », du fait que l'émetteur, formé par la couche 20 qui est dopée p+, est disposé en face arrière de la cellule 10. Dans cette configuration, grâce à la même polarité du substrat 12 et de la couche 18 située en face avant de la cellule 10, la collecte des charges est facilitée, par circulation dans le substrat 12 cristallin. Cela permet de réduire les contraintes sur les propriétés électriques de la couche d'OTC 22 localisée en face avant, et donc d'envisager une réduction de la consommation d'indium liée à cette couche. Pour cela, il est possible d'envisager :
- un abaissement significatif de l'épaisseur de la couche d'OTC 22, qui est dans ce cas recouverte par une couche antireflet afin d'assurer une transmission optique optimale dans la cellule 10, ou
- un remplacement de l'indium de la couche d'OTC 22 par un matériau alternatif ayant une moins bonne conductivité électrique, tel que l'oxyde de zinc dopé à l'aluminium (AZO).

Dans le cas de la cellule 10 qui est dans une configuration à émetteur inversé, la couche d'OTC 22 en face avant ne doit ainsi répondre qu'à deux principaux critères :
- présenter des résistivités de contacts faibles aux interfaces avec le silicium polycristallin de la couche 18 et les métallisations 28 ;
- présenter un niveau de transmission optique élevé, ainsi qu'une réflectivité minimale (l'optimum de réflectivité peut être ajusté par dépôt d'une couche antireflet).

En théorie, le cas optique idéal correspondrait à une épaisseur nulle de la couche d'OTC 22 du fait d'une forte absorption, notamment dans les rayonnements proches ultra-violet (UV), de cette couche 22. Les contraintes électriques qui s'imposent à la cellule 10 ne permettent cependant pas de se passer de cette couche dans la cellule à l'échelle industrielle. Des premiers développements sans utilisation de couches OTC sont cependant présentés dans les travaux de S. Li et al., « Transparent-conductive-oxide-free front contacts for high-efficiency silicon heterojunction solar cells », Joule, vol. 5, no 6, p. 1535-1547, juin 2021.

Le document D. L. Young et al., « Reactive ion etched, self-aligned, sélective area poly-Si/SiO2 passivated contacts », Sol. Energy Mater. Sol. Cells, vol. 217, p. 110621, nov. 2020, propose de graver par RIE (gravure ionique réactive) une grande partie de l'épaisseur de la couche de polysilicium localisée en face avant, en utilisant les métallisations comme masque de gravure afin de ne pas graver les parties de la couche de polysilicium localisées sous les métallisations. Bien que la cellule obtenue présente des propriétés intéressantes, la mise en oeuvre d'une telle gravure RIE est difficile à mettre en oeuvre car les équipements de gravure RIE sont peu présents dans l'industrie photovoltaïque.

Le document « Contact électrodes for heterojunction silicon solar cells : Evaluations and optimizations of the électron contact », de Léo Basset, thèse de doctorat de l'Université de Lille, 10 novembre 2020, pages 85-96, décrit, dans le but d'obtenir des résistivités de contact faibles aux interfaces avec le silicium polycristallin et les métallisations, la mise en oeuvre d'une gravure par voie humide de la couche d'OTC avec un recours à un masquage sacrificiel, insensible à la solution de gravure de la couche d'OTC. Ce masque est ensuite décapé par une solution chimique, n'affectant pas la couche d'OTC. Les électrodes métalliques sont ensuite déposées en alignant précisément le métal sur les portions de la couche d'OTC. Cette approche nécessite toutefois un nombre important d'étapes, ainsi qu'une précision d'opération importante pour réaliser les électrodes métalliques sur les portions non gravées de la couche d'OTC.

Le document EP 2 963 691 A1 décrit la réalisation d'une cellule à émetteur inversé dans laquelle la couche d'OTC se trouvant en face avant et/ou la couche d'OTC se trouvant en face arrière de la cellule comporte une épaisseur réduite, voire nulle, dans les régions qui ne sont pas surmontées par les électrodes métalliques de la cellule. Ce document ne décrit toutefois aucun procédé qui permettrait de réaliser une telle cellule.

### EXPOSÉ DE L'INVENTION

Un but de la présente invention est de proposer une cellule photovoltaïque à contacts passivés en double face dont les propriétés optiques et électriques soient améliorées, et dont la réalisation soit possible avec des équipements classiquement utilisés dans l'industrie photovoltaïque.

Pour cela, la présente invention propose une cellule photovoltaïque comportant au moins :
- un substrat semi-conducteur cristallin d'un premier type de conductivité, comprenant une première face disposée du côté d'une face avant de la cellule destinée à recevoir une lumière incidente, et une deuxième face disposée du côté d'une face arrière, opposée à la face avant, de la cellule ;
- une première couche de passivation disposée contre la première face du substrat, et une deuxième couche de passivation disposée contre la deuxième face du substrat ;
- une première couche de semi-conducteur sélective de charge dopée selon le premier type de conductivité et disposée contre la première couche de passivation, et une deuxième couche de semi-conducteur sélective de charge dopée selon un deuxième type de conductivité, opposé au premier type de conductivité, et disposée contre la deuxième couche de passivation ;
- une première couche d'oxyde d'indium disposée entre des contacts électriques de face arrière de la cellule et la deuxième couche de semi-conducteur sélective de charge ;
- des premières portions d'oxyde transparent conducteur comportant du zinc, disposées entre des contacts électriques de face avant de la cellule et des premières régions de la première couche de semi-conducteur sélective de charge ;
et dans laquelle des deuxièmes régions de la première couche de semi-conducteur sélective de charge, localisées entre et/ou à côté des premières régions de la première couche de semi-conducteur sélective de charge, ne sont pas recouvertes d'oxyde transparent conducteur comportant du zinc ou sont recouvertes de deuxièmes portions d'oxyde transparent conducteur comportant du zinc de plus faible épaisseur que celle des premières portions d'oxyde transparent conducteur comportant du zinc.

Dans cette cellule photovoltaïque, il est proposé d'utiliser un oxyde transparent conducteur à base de zinc localisé soit uniquement sous les électrodes métalliques avant, soit majoritairement sous ces électrodes métalliques avant. Cette configuration particulière permet notamment d'augmenter le courant dans la cellule grâce à la suppression de l'absorption parasite provoquée, dans les cellules de l'art antérieur, par l'oxyde transparent conducteur épais présent au niveau de toute la surface avant de la cellule.

L'utilisation, au niveau de la face avant de la cellule, d'un oxyde transparent conducteur comportant du zinc permet de réduire la consommation d'indium pour la réalisation de la cellule étant donné que l'oxyde d'indium n'est pas nécessairement utilisé au niveau de la face avant de la cellule.

En outre, cette absence ou cette plus fine épaisseur d'oxyde transparent conducteur au niveau des régions de la face avant localisées entre les contacts électriques avant de la cellule a pour conséquence d'augmenter la stabilité dans le temps de la cellule grâce à la suppression des phénomènes de vieillissement optique de l'oxyde transparent conducteur (opacification sous l'effet du rayonnement UV notamment).

L'oxyde transparent conducteur comportant du zinc ne comporte pas d'indium.

Les couches de semi-conducteur sélectives de charge peuvent correspondre à des couches de semi-conducteur polycristallin ou amorphe.

De manière avantageuse, la cellule photovoltaïque peut être telle qu'au moins l'une des propriétés suivantes soit vérifiée :
- l'oxyde transparent conducteur comportant du zinc peut être de l'oxyde de zinc dopé à l'aluminium (AZO) ou dopé au bore (BZO), ou de l'oxyde de zinc dopé aux deux éléments bore et aluminium (BAZO) ;
- l'oxyde d'indium peut être dopé avec au moins l'un des éléments suivants : étain, hydrogène, zinc, cérium, tungstène ;
- les première et deuxième couches de passivation peuvent comporter de l'oxyde de silicium SiOx et/ou du silicium amorphe intrinsèque hydrogéné a-Si:H(i) ;

- les contacts électriques de face avant et/ou les contacts électriques de face arrière peuvent comporter au moins l'un des éléments suivants : argent, cuivre, aluminium ;
- le semi-conducteur du substrat et des première et deuxième couches de semi-conducteur sélectives de charge peut comporter du silicium.

Selon d'autres configurations, des métaux autres que le cuivre, l'argent et l'aluminium peuvent être utilisés pour réaliser les contacts électriques de la cellule.

La première couche d'oxyde d'indium peut comporter une épaisseur homogène sur l'ensemble de la surface de la deuxième couche de semi-conducteur sélective de charge. La cellule peut comporter en outre un matériau antireflet, avantageusement du SiO_{X}N_{Y}:H, recouvrant les contacts électriques de face avant et les deuxièmes régions de la première couche de semi-conducteur sélective de charge.

La présence de ce matériau antireflet augmente la stabilité dans le temps de la cellule grâce à l'effet protecteur, ou encapsulant, procuré par ce matériau antireflet. En outre, le dépôt de ce matériau antireflet a également pour avantage d'améliorer la passivation de la première couche de semi-conducteur sélective de charge. Ce matériau antireflet peut permettre un piégeage optique optimal du rayonnement lumineux incident en face avant de la cellule, et ainsi maximiser le courant produit par la cellule.

Dans une configuration particulière, la cellule peut comporter en outre une deuxième couche d'oxyde d'indium disposée contre la première couche de semi-conducteur sélective de charge, des parties de cette deuxième couche d'oxyde d'indium étant disposées entre les premières régions de la première couche de semi-conducteur sélective de charge et les premières portions d'oxyde transparent conducteur comportant du zinc, et dans laquelle l'épaisseur de la deuxième couche d'oxyde d'indium est inférieure ou égale à 15 nm.

La cellule décrite dans ce document peut correspondre à une cellule à contacts passivés, ou toute cellule faisant appel à des contacts via des couches d'OTC, comme par exemple une cellule de type TOPCon (à contacts passivés par oxyde de silicium tunnel), une cellule à structure à hétérojonction basse température, une cellule à multi-jonctions. En particulier, cette cellule peut correspondre à une cellule utilisant un contact passivé type hétérojonction de silicium (a-Si:H(dopé)/a-Si:H(i)) ou de type TOPCon double face poly-Si(dopé)/SiOx.

Dans un mode de réalisation particulier :
- la cellule photovoltaïque peut être une cellule photovoltaïque tandem, et
- le substrat, les première et deuxième couches de passivation, et les première et deuxième couches de semi-conducteur sélective de charge peuvent former une première sous-cellule de la cellule photovoltaïque tandem ;
- la cellule photovoltaïque tandem peut comporter en outre une deuxième sous-cellule disposée entre la première couche d'oxyde d'indium et la première sous-cellule.

La deuxième sous-cellule peut comporter au moins une couche de matériau de structure pérovskite. En variante, la deuxième sous-cellule peut être de type CIGS, ou GaAs.

La cellule peut comporter en outre une couche d'oxyde transparent conducteur comportant du zinc disposée entre la première couche d'oxyde d'indium et la deuxième couche de semi-conducteur sélective de charge.

Il est également proposé un procédé de réalisation d'une cellule photovoltaïque, comportant au moins :
- réalisation d'une première couche de passivation contre une première face d'un substrat semi-conducteur cristallin d'un premier type de conductivité, la première face du substrat étant destinée à être disposée du côté d'une face avant de la cellule destinée à recevoir une lumière incidente, et d'une deuxième couche de passivation contre une deuxième face du substrat disposée du côté d'une face arrière, opposée à la face avant, de la cellule ;
- réalisation, contre la première couche de passivation, d'une première couche de semi-conducteur sélective de charge dopée selon le premier type de conductivité, et d'une deuxième couche de semi-conducteur sélective de charge dopée selon un deuxième type de conductivité, opposé au premier type de conductivité, contre la deuxième couche de passivation ;
- dépôt d'une première couche d'oxyde d'indium sur la deuxième couche de semi-conducteur sélective de charge, et dépôt d'une couche d'oxyde transparent conducteur comportant du zinc sur la première couche de semi-conducteur sélective de charge ;
- réalisation de contacts électriques de face arrière de la cellule sur la première couche d'oxyde d'indium et de contact électriques de face avant de la cellule sur la couche d'oxyde transparent conducteur comportant du zinc ;
- gravure au moins partielle des parties de la couche d'oxyde transparent conducteur comportant du zinc non recouvertes par les contacts électriques de face avant, conservant des premières portions de la couche d'oxyde transparent conducteur comportant du zinc disposées entre les contacts électriques de face avant et des premières régions de la première couche de semi-conducteur sélective de charge, et telle que des deuxièmes régions de la première couche de semi-conducteur sélective de charge, localisées entre et/ou à côté des premières régions de la première couche de semi-conducteur sélective de charge, ne soient pas recouvertes d'oxyde transparent conducteur comportant du zinc ou soient recouvertes de deuxièmes portions de la couche d'oxyde transparent conducteur comportant du zinc de plus faible épaisseur que celle des premières portions d'oxyde transparent conducteur comportant du zinc.

Ce procédé propose d'effectuer la localisation de l'oxyde transparent conducteur sous les contacts électriques de face avant. Plus précisément, il est proposé un processus de gravure, par exemple une gravure humide sélective, sur une large surface de l'OTC comportant du zinc, dans lequel les métallisations, déposées préalablement sur cet OTC, remplissent à elles seules le rôle de masquage à la gravure, sans impact sur leur fonctionnalité, et permettant d'apporter des effets bénéfiques à la cellule (courant, stabilité dans le temps, hydrogénation). L'écart de cinétique de gravure entre l'OTC comportant du zinc et l'oxyde d'indium permet en outre de ne pas à avoir recours à un masquage du côté de la face arrière de la cellule.

Ce procédé permet une réduction des étapes de gravure dans le cas de procédé par voie humide en ne recourant pas à un masquage sacrificiel, avec des réactifs déjà largement utilisés dans l'industrie photovoltaïque, et grâce à la différence de cinétique entre les OTC à base de zinc et les OTC à base d'indium.

Selon une configuration particulière, la gravure peut être mise en oeuvre en plongeant la cellule dans un bain d'acide chlorhydrique dilué par de l'eau distillée avec un facteur de dilution compris entre 500 et 1000, pendant une durée comprise entre 25 secondes et 60 secondes. Une telle gravure est bien adaptée à la configuration de la cellule dans laquelle la largeur de gravure est importante (par exemple de l'ordre de 1,5 mm, correspondant à la largeur de la région entre deux contacts électriques de face avant voisins) et de la faible largeur des contacts électriques de face avant (par exemple égale à environ 50 µm) afin de limiter au maximum l'ombrage lié à la métallisation. Ces deux aspects pris en compte (large surface de gravure + faible largeur de masquage par la sérigraphie), le traitement chimique proposé est très bien adapté pour enlever l'intégralité de la couche d'OTC entre les métallisations avant, tout en ne retirant pas l'OTC sur la largeur des métallisations avant.

Le procédé peut comporter en outre, après la gravure, un dépôt d'un matériau antireflet, avantageusement du SiO_{X}N_{Y}:H, recouvrant les contacts électriques de face avant et les deuxièmes régions de la première couche de semi-conducteur sélective de charge.

Le procédé peut comporter en outre, entre la réalisation des contacts électriques et la gravure, la mise en oeuvre d'un recuit sous atmosphère de N₂, à une température comprise entre 200°C et 400°C, ou entre 300°C et 400°C, et pendant une durée comprise entre 2 minutes et 10 minutes, ou entre 5 minutes et 10 minutes. Un tel recuit permet de stabiliser la valeur du facteur de forme (FF) de la cellule pour différentes durées de gravure.

Selon un mode de réalisation particulier :
- la cellule photovoltaïque réalisée peut être une cellule photovoltaïque tandem ;
- le substrat, les première et deuxième couches de passivation, et les première et deuxième couches de semi-conducteur sélective de charge peuvent former une première sous-cellule de la cellule photovoltaïque ;
et le procédé peut comporter en outre, entre la réalisation des contacts électriques et la gravure, la réalisation d'une deuxième sous-cellule disposée entre la première couche d'oxyde d'indium et la première sous-cellule.

Dans l'ensemble du document, le terme « sur » est utilisé sans distinction de l'orientation dans l'espace de l'élément auquel ce rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments. Dans tout le document, le terme « couche » est utilisé pour désigner soit une unique couche de matériau, soit un empilement de plusieurs couches distinctes superposées les unes au-dessus des autres.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- La figure 1 représente un exemple de réalisation d'une cellule photovoltaïque à contacts passivés intégrés en double face ;
- La figure 2 représente un exemple de réalisation d'une cellule photovoltaïque à contacts passivés, objet de la présente invention, selon un premier mode de réalisation ;
- La figure 3 représente un exemple de réalisation d'une cellule photovoltaïque à contacts passivés, objet de la présente invention, selon un deuxième mode de réalisation ;
- La figure 4 un exemple de réalisation d'une cellule photovoltaïque à contacts passivés, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

Un exemple de réalisation d'une cellule photovoltaïque 100 à contacts passivés selon un premier mode de réalisation est décrit ci-dessous en lien avec la figure 2.

La cellule photovoltaïque 100 comporte un substrat 102 semi-conducteur cristallin d'un premier type de conductivité. De manière avantageuse, le semi-conducteur du substrat 102 correspond à du silicium. Dans l'exemple de réalisation décrit ici, le premier type de conductivité correspond à une conductivité de type n. A titre d'exemple, le substrat 102 peut correspondre à un wafer standard M2 (environ 156 mm de côté), ou d'une autre dimension.

Le substrat 102 comprend une première face 104 disposée du côté d'une face avant de la cellule 100 qui est destinée à recevoir une lumière incidente, et une deuxième face 106 disposée du côté d'une face arrière, opposée à la face avant, de la cellule 100.

La cellule 100 comporte une première couche de passivation 108 disposée contre la première face 104 du substrat 102, et une deuxième couche de passivation 110 disposée contre la deuxième face 106 du substrat 102. Dans l'exemple de réalisation décrit ici, les première et deuxième couches de passivation 108, 110 comportent de l'oxyde de silicium (SiOx) ou du silicium amorphe intrinsèque hydrogéné (a-Si:H(i)). Les épaisseurs des première et deuxième couches de passivation 108, 110 sont par exemple comprises entre 1 nm et 10 nm.

La cellule 100 comporte également une première couche de semi-conducteur sélective de charge 112 dopée selon le premier type de conductivité et disposée contre la première couche de passivation 108, et une deuxième couche de semi-conducteur sélective de charge 114 dopée selon un deuxième type de conductivité, opposé au premier type de conductivité, disposée contre la deuxième couche de passivation 110. De manière avantageuse, les première et deuxième couches de semi-conducteur sélective de charge 112, 114 comportent du silicium polycristallin dopé ou du silicium amorphe hydrogéné dopé. Les épaisseurs des première et deuxième couches de semi-conducteur sélective de charge 112, 114 sont par exemple comprises entre 5 nm et 20 nm.

La cellule 100 comporte également une couche d'oxyde d'indium 116 disposée entre des contacts électriques 118 de face arrière de la cellule 100 et la deuxième couche de semi-conducteur sélective de charge 114. La couche 116 peut notamment comporter de l'oxyde d'indium dopé à l'étain, hydrogéné ou non (ITO:H ou ITO). Il est également possible que la couche 116 comporte de l'oxyde d'indium hydrogéné (IO:H), c'est-à-dire non dopé à l'étain. La couche 116 comporte par exemple une épaisseur égale à 100 nm, ou par exemple comprise entre 70 nm et 100 nm.

La cellule 100 comporte également des premières portions 120 d'oxyde transparent conducteur comportant du zinc disposées entre des contacts électriques 122 de face avant de la cellule 100 et des premières régions 124 de la première couche de semi-conducteur sélective de charge 112. De manière avantageuse, l'oxyde transparent conducteur comportant du zinc est de l'oxyde de zinc dopé à l'aluminium (AZO) ou dopé au bore (BZO). L'épaisseur (dimension selon l'axe Z représenté sur la figure 2) des premières portions 120 est par exemple égale à 70 nm, ou plus généralement comprise entre 0 et 70 nm.

Dans la cellule 100 selon l'exemple de réalisation représenté sur la figure 2, des deuxièmes régions 126 de la première couche de semi-conducteur sélective de charge 112, localisées entre et/ou à côté des premières régions 124 de la première couche de semi-conducteur sélective de charge 112, ne sont pas recouvertes d'oxyde transparent conducteur comportant du zinc. Selon une variante, il est possible que les deuxièmes régions 126 soient recouvertes de deuxièmes portions d'oxyde transparent conducteur comportant du zinc de plus faible épaisseur que celle des premières portions 120 et par exemple issues de la même couche que celle ayant servie à la réalisation des premières portions 120.

De manière avantageuse, les contacts électriques 118, 122, ou métallisations, de la cellule 100 comportent de l'argent ou du cuivre. D'autres métaux sont toutefois possibles pour former les contacts électriques 118, 122

De manière avantageuse, et comme c'est le cas dans l'exemple de réalisation représenté sur la figure 2, la cellule 100 comporte en outre un matériau antireflet 128 recouvrant les contacts électriques 122 de face avant et les deuxièmes régions 126 de la première couche de semi-conducteur sélective de charge 112. De manière avantageuse, le matériau antireflet 128 est riche en hydrogène et correspond par exemple à du SiO_{X}N_{Y}:H, ce qui lui permet d'assurer un piégeage optique optimal du rayonnement lumineux incident en face avant de la cellule 100, et ainsi maximiser le courant produit par la cellule 100. L'épaisseur du matériau antireflet 128 déposé est par exemple égale à 95 nm, ou comprise entre 50 nm et 200 nm.

Une cellule 100 telle que celle décrite ci-dessus peut présenter les caractéristiques suivantes :
- tension de circuit ouvert supérieure à 690 mV ;
- courant de court-circuit supérieur à 39 mA/cm² ;
- altération du facteur de forme (FF) inférieure à 80 %, en raison de la perte de conductivité latérale due à l'absence d'oxyde transparent conducteur sur les deuxièmes régions 126.

Dans l'exemple de réalisation représenté sur la figure 2, la première face 104 du substrat 102 est texturée et forme des motifs antireflets qui se retrouvent au niveau de la face avant de la cellule 100.

Pour réaliser la cellule 100 telle que représentée sur la figure 2, la face avant 104 du substrat 102 est tout d'abord texturée, puis les couches de passivation 108, 110 sont formées, par exemple par croissance chimique et/ou thermique, sur les faces 104, 106 du substrat 102.

Les couches de semi-conducteur sélective de charge 112, 114 sont ensuite réalisées sur les couches de passivation 108, 110.

Selon un exemple de réalisation, les couches 112, 114 sont par exemple réalisées en déposant tout d'abord des couches de silicium amorphe intentionnellement non-dopée, par exemple par dépôt chimique en phase vapeur basse pression (LPCVD), sur les couches de passivation 108, 110.

Un dopage de type n du silicium amorphe déposé sur la couche 108 est ensuite mis en oeuvre, par exemple par implantation ionique par immersion plasma (PIII) mise en oeuvre avec de la phosphine (PH₃). Cette implantation est par exemple réalisée en utilisant une tension d'accélération de l'ordre de 4 kV et une dose de l'ordre de 7,5.10¹⁵ at/cm².

Un dopage de type p du silicium amorphe déposé sur la couche 120 est ensuite mis en oeuvre, par exemple par implantation ionique par immersion plasma (PIII) mise en oeuvre avec du diborane (B₂H₆). Cette implantation est par exemple réalisée en utilisant une tension d'accélération de l'ordre de 6 kV et une dose de l'ordre de 7.10¹⁵ at/cm².

Un recuit d'activation des dopants et de cristallisation est ensuite mis en oeuvre, par exemple à une température de 875 °C, pendant 30 mn et sous atmosphère de N₂, transformant les couches de semi-conducteur amorphes dopées en couches de semi-conducteur polycristallin dopées.

La couche d'oxyde d'indium 116 est ensuite déposée sur la deuxième couche de semi-conducteur sélective de charge 114, et une couche d'oxyde transparent conducteur comportant du zinc est déposée sur la première couche de semi-conducteur sélective de charge 112. Ces oxydes transparents conducteurs sont par exemple déposés par pulvérisation cathodique.

Les contacts électriques 118, 122 sont ensuite réalisés respectivement sur la couche d'oxyde transparent conducteur comportant du zinc et sur la couche d'oxyde d'indium 116, par sérigraphie. En variante, les contacts électriques 118, 122 peuvent être réalisés par d'autres techniques, comme par exemple le dépôt par évaporation, l'électro-dépôt, etc.

Une gravure est ensuite mise en oeuvre afin de réduire l'épaisseur ou de supprimer (ce qui est le cas pour la réalisation de la cellule 100 représentée sur la figure 2) les parties de la couche d'oxyde transparent conducteur comportant du zinc non recouvertes par les contacts électriques 122. Dans l'exemple de réalisation décrit ici, à l'issue de cette gravure, seules des premières portions 120 de la couche d'oxyde transparent conducteur comportant du zinc disposées entre les contacts électriques 122 de face avant et les premières régions 124 de la première couche de semi-conducteur sélective de charge 112 sont conservées.

La gravure est avantageusement mise en oeuvre en plongeant tous les éléments de la cellule précédemment réalisés dans un bain d'acide chlorhydrique dilué par de l'eau avec un facteur de dilution compris entre 500 et 1000 (avantageusement égal à environ 800), pendant une durée comprise entre 25 secondes et 60 secondes (par exemple de l'ordre de 40 secondes lorsque le facteur de dilution est égal à 800). La durée de mise en oeuvre de cette gravure est adaptée notamment en fonction du facteur de dilution de la solution de gravure utilisée ainsi que de l'épaisseur de la couche d'oxyde transparent conducteur comportant du zinc à graver.

Le faible temps nécessaire pour graver la couche d'oxyde transparent conducteur comportant du zinc permet de ne pas endommager, ou très peu, les portions 120 de cette couche localisées sous les contacts électriques avant 122 et qui les maintiennent mécaniquement. Par exemple, lorsque la largeur (dimension selon l'axe X représenté sur la figure 2) des contacts 122 est égale à environ 50 µm, la gravure mise en oeuvre peut réduire d'environ 5 µm la largeur des portions 120, ce qui n'empêche pas le maintien mécanique des contacts électriques 122 par les portions 120 obtenues à l'issue de cette gravure.

Durant cette gravure, la face arrière de la cellule, formée par la couche d'oxyde d'indium 116, ne nécessite pas de protection particulière du fait de son absence de gravure ou de sa très lente cinétique dans le bain d'acide chlorhydrique utilisé, en comparaison de l'oxyde transparent conducteur à base de zinc gravé.

Après la gravure, la cellule est par exemple rincée à l'eau dé-ionisée, puis séchée par étuvage.

Un dépôt, par exemple de type PECVD, du matériau antireflet 128 recouvrant les contacts électriques 122 de face avant et les deuxièmes régions 126 de la première couche de semi-conducteur sélective de charge 112 est ensuite mis en oeuvre. Ce dépôt est par exemple mis en oeuvre à une température de 320°C.

Dans une variante avantageuse, entre la réalisation des contacts électriques 118, 122 et la gravure de la couche 112, un recuit sous atmosphère de N₂, à une température comprise entre 200°C et 400°C, ou avantageusement entre 300°C et 400°C, et par exemple égale à 350°C et pendant une durée comprise entre 2 minutes et 10 minutes, ou entre 5 minutes et 10 minutes, et par exemple égale à 5 minutes, peut être mis en oeuvre. Un tel recuit permet de stabiliser la valeur du facteur de forme (FF) de la cellule 100 pour différentes durées de gravure.

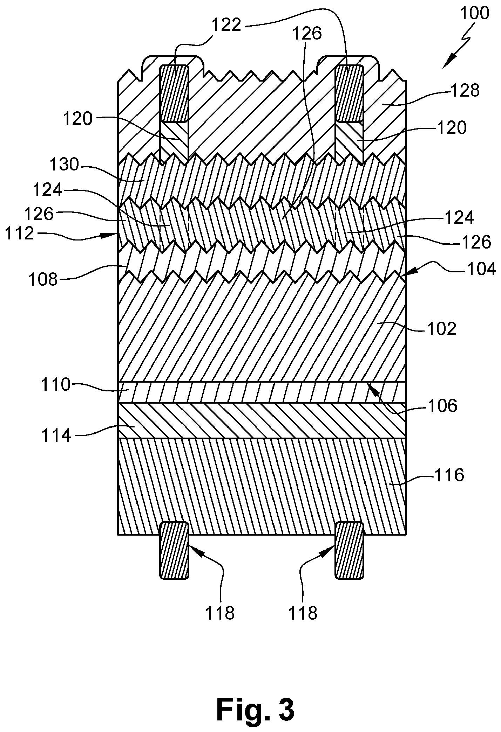

Un exemple de réalisation d'une cellule photovoltaïque 100 à contacts passivés selon un deuxième mode de réalisation est décrit ci-dessous en lien avec la figure 3.

Outre les éléments de la cellule 100 précédemment décrits en lien avec la figure 2, la cellule 100 selon ce deuxième mode de réalisation comporte une deuxième couche 130 d'oxyde d'indium, ici dopé à l'étain et hydrogéné ou non, disposée sur la première couche de semi-conducteur sélective de charge 112, sous les premières portions d'oxyde transparent conducteur comportant du zinc 120 et sous le matériau antireflet 128 se trouvant entre et à côté des portions 120. L'épaisseur de cette couche 130 d'oxyde d'indium est inférieure ou égale à 15 nm afin de garantir une bonne conductivité électrique latérale.

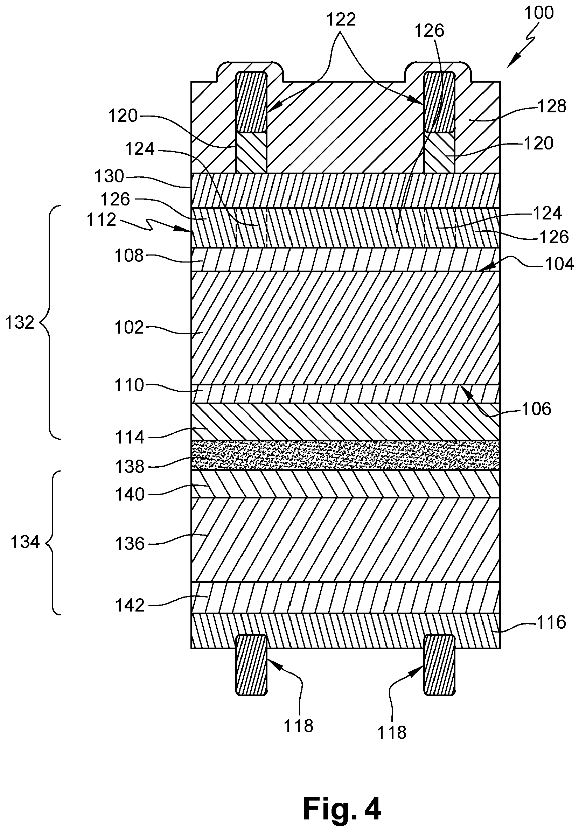

Un exemple de réalisation d'une cellule photovoltaïque 100 à contacts passivés selon un troisième mode de réalisation est décrit ci-dessous en lien avec la figure 4.

Dans ce troisième mode de réalisation, la cellule 100 correspond à une cellule tandem silicium / pérovskite. Le substrat 102, les première et deuxième couches de passivation 108, 110, et les première et deuxième couches de semi-conducteur sélectives de charge 112, 114 forment une première sous-cellule 132 de la cellule photovoltaïque tandem 100. La cellule photovoltaïque tandem 100 comporte en outre une deuxième sous-cellule 134 disposée entre la première couche d'oxyde d'indium 116 et la première sous-cellule 132. Selon un mode de réalisation, la deuxième sous-cellule 134 peut comporter au moins une couche de matériau absorbeur 136, par exemple de structure pérovskite. Cette couche de matériau absorbeur 136 comporte par exemple du MAPbl₃. La couche 136 est par exemple formée par centrifugation ou par enduction à filière plate. La couche 136 a par exemple une épaisseur comprise entre 500 nm et 1 µm.

Sur l'exemple de la figure 4, la cellule 100 comporte également une interface 138 disposée entre les deux sous-cellules 132, 134 et correspondant par exemple à une jonction tunnel à base de silicium, ou une jonction tunnel à base d'oxyde transparent conducteur. En variante, il possible que la cellule 100 ne comporte par l'interface 138 et que les deux sous-cellules 132, 134 soient disposées directement l'une contre l'autre.

La deuxième sous-cellule 134 représentée sur la figure 4 comporte également une couche de transport d'électrons 140, ou ETL pour « Electron Transport Layer » en anglais, disposée entre l'interface 138 et la couche de matériau absorbeur 136. La couche de transport d'électrons 140 comporte par exemple au moins l'un des matériaux suivants : TiO₂, ZnO, SnO₂. Cette couche de transport d'électrons 140 est par exemple formée par un dépôt de type ALD (« Atomic Layer Déposition » en anglais, ou dépôt de couche atomique). La couche de transport d'électrons 140 a par exemple une épaisseur comprise entre 5 nm et 30 nm.

La deuxième sous-cellule 134 représentée sur la figure 4 comporte également une couche de transport de trous 142, ou HTL pour « Hole Transport Layer » en anglais, disposée entre la couche de matériau absorbeur 136 et la couche d'oxyde d'indium dopé à l'étain 116. La couche 142 comporte par exemple du PTAA (poly-phényl-trimetyl-amine). La couche 142 est par exemple formée par centrifugation. La couche 136 a par exemple une épaisseur comprise entre 20 nm et 50 nm.

Dans l'exemple de réalisation décrit ci-dessus, la deuxième sous-cellule 134 comprend une couche de matériau absorbeur 136 à base de matériau pérovskite. En variante, la deuxième sous-cellule 134 peut être à base d'un autre type de matériau, comme par exemple de type CIGS ou à base de GaAs.

Lors de la réalisation de la cellule 100 selon ce troisième mode de réalisation, le recuit sous atmosphère de N₂ précédemment décrit avant la gravure de la couche d'oxyde transparent conducteur comportant du zinc peut ne pas être mis en oeuvre afin de ne pas endommager les matériaux de la sous-cellule 134.

En variante de tous les modes de réalisation précédemment décrits, il est possible que la cellule 100 comporte une couche d'oxyde transparent conducteur comportant du zinc, disposée entre la couche d'oxyde d'indium 116 et la deuxième couche de semi-conducteur sélective de charge 114 (ou entre la couche d'oxyde d'indium 116 et la deuxième sous-cellule 134 dans le cas de la cellule tandem 100 selon le troisième mode de réalisation précédemment décrit).

## Revendications

1. Cellule photovoltaïque (100) comportant au moins :
- un substrat (102) semi-conducteur cristallin d'un premier type de conductivité, comprenant une première face (104) disposée du côté d'une face avant de la cellule (100) destinée à recevoir une lumière incidente, et une deuxième face (106) disposée du côté d'une face arrière, opposée à la face avant, de la cellule (100) ;
- une première couche de passivation (108) disposée contre la première face (104) du substrat (102), et une deuxième couche de passivation (110) disposée contre la deuxième face (106) du substrat (102) ;
- une première couche de semi-conducteur sélective de charge (112) dopée selon le premier type de conductivité et disposée contre la première couche de passivation (108), et une deuxième couche de semi-conducteur sélective de charge (114) dopée selon un deuxième type de conductivité, opposé au premier type de conductivité, et disposée contre la deuxième couche de passivation (110) ;
- une première couche d'oxyde d'indium (116) disposée entre des contacts électriques (118) de face arrière de la cellule (100) et la deuxième couche de semi-conducteur sélective de charge (114) ;
- des premières portions (120) d'oxyde transparent conducteur comportant du zinc, disposées entre des contacts électriques (122) de face avant de la cellule (100) et des premières régions (124) de la première couche de semi-conducteur sélective de charge (112) ;
et dans laquelle des deuxièmes régions (126) de la première couche de semi-conducteur sélective de charge (112), localisées entre et/ou à côté des premières régions (124) de la première couche de semi-conducteur sélective de charge (112), ne sont pas recouvertes d'oxyde transparent conducteur comportant du zinc ou sont recouvertes de deuxièmes portions d'oxyde transparent conducteur comportant du zinc de plus faible épaisseur que celle des premières portions (120) d'oxyde transparent conducteur comportant du zinc.

2. Cellule photovoltaïque (100) selon la revendication 1, présentant au moins l'une des propriétés suivantes :
- l'oxyde transparent conducteur comportant du zinc est de l'oxyde de zinc dopé à l'aluminium ou dopé au bore, ou dopé à l'aluminium et au bore ;
- l'oxyde d'indium est dopé avec au moins l'un des éléments suivants : étain, hydrogène, zinc, cérium, tungstène ;
- les première et deuxième couches de passivation (108, 110) comportent de l'oxyde de silicium et/ou du silicium amorphe hydrogéné intrinsèque ;
- les contacts électriques (122) de face avant et/ou les contacts électriques (118) de face arrière comportent au moins l'un des éléments suivants : argent, cuivre, aluminium ;
- le semi-conducteur du substrat (102) et des première et deuxième couches de semi-conducteur sélectives de charge (112, 114) comporte du silicium.

3. Cellule photovoltaïque (100) selon l'une des revendications précédentes, dans laquelle la première couche d'oxyde d'indium (116) comporte une épaisseur homogène sur l'ensemble de la surface de la deuxième couche de semi-conducteur sélective de charge (114).

4. Cellule photovoltaïque (100) selon l'une des revendications précédentes, comportant en outre un matériau antireflet (128) recouvrant les contacts électriques (122) de face avant et les deuxièmes régions (126) de la première couche de semi-conducteur sélective de charge (112).

5. Cellule photovoltaïque (100) selon la revendication 4, dans lequel le matériau antireflet (128) est du SiO_{X}N_{Y}:H.

6. Cellule photovoltaïque (100) selon l'une des revendications précédentes, comportant en outre une deuxième couche d'oxyde d'indium (130) disposée contre la première couche de semi-conducteur sélective de charge (112), des parties de cette deuxième couche d'oxyde d'indium (130) étant disposées entre les premières régions (124) de la première couche de semi-conducteur sélective de charge (112) et les premières portions (120) d'oxyde transparent conducteur comportant du zinc, et dans laquelle l'épaisseur de la deuxième couche d'oxyde d'indium (130) est inférieure ou égale à 15 nm.

7. Cellule photovoltaïque (100) selon l'une des revendications précédentes, dans laquelle :
- la cellule photovoltaïque (100) est une cellule photovoltaïque tandem ;
- le substrat (102), les première et deuxième couches de passivation (108, 110), et les première et deuxième couches de semi-conducteur sélectives de charge (112, 114) forment une première sous-cellule (132) de la cellule photovoltaïque (100) ;
- la cellule photovoltaïque (100) comporte en outre une deuxième sous-cellule (134) disposée entre la première couche d'oxyde d'indium (116) et la première sous-cellule (132).

8. Cellule photovoltaïque (100) selon la revendication 7, dans laquelle la deuxième sous-cellule (134) comporte au moins une couche de matériau de structure pérovskite (136).

9. Cellule photovoltaïque (100) selon l'une des revendications précédentes, comportant en outre une couche d'oxyde transparent conducteur comportant du zinc disposée entre la première couche d'oxyde d'indium (116) et la deuxième couche de semi-conducteur sélective de charge (114).

10. Procédé de réalisation d'une cellule photovoltaïque (100), comportant au moins :
- réalisation d'une première couche de passivation (108) contre une première face (104) d'un substrat (102) semi-conducteur cristallin d'un premier type de conductivité, la première face (104) du substrat (102) étant destinée à être disposée du côté d'une face avant de la cellule (100) destinée à recevoir une lumière incidente, et d'une deuxième couche de passivation (110) contre une deuxième face (106) du substrat (102) disposée du côté d'une face arrière, opposée à la face avant, de la cellule (100) ;
- réalisation, contre la première couche de passivation (108), d'une première couche de semi-conducteur sélective de charge (112) dopée selon le premier type de conductivité, et d'une deuxième couche de semi-conducteur sélective de charge (114) dopée selon un deuxième type de conductivité, opposé au premier type de conductivité, contre la deuxième couche de passivation (110) ;
- dépôt d'une première couche d'oxyde d'indium (116) sur la deuxième couche de semi-conducteur sélective de charge (114), et dépôt d'une couche d'oxyde transparent conducteur comportant du zinc sur la première couche de semi-conducteur sélective de charge (112) ;
- réalisation de contacts électriques (118) de face arrière de la cellule (100) sur la première couche d'oxyde d'indium (116) et de contact électriques (122) de face avant de la cellule (100) sur la couche d'oxyde transparent conducteur comportant du zinc ;
- gravure au moins partielle des parties de la couche d'oxyde transparent conducteur comportant du zinc non recouvertes par les contacts électriques (122) de face avant, conservant des premières portions (120) de la couche d'oxyde transparent conducteur comportant du zinc disposées entre les contacts électriques (122) de face avant et des premières régions (124) de la première couche de semi-conducteur sélective de charge (112), et telle que des deuxièmes régions (126) de la première couche de semi-conducteur sélective de charge (112), localisées entre et/ou à côté des premières régions (124) de la première couche de semi-conducteur sélective de charge (112), ne soient pas recouvertes d'oxyde transparent conducteur comportant du zinc ou soient recouvertes de deuxièmes portions de la couche d'oxyde transparent conducteur comportant du zinc de plus faible épaisseur que celle des premières portions (120) d'oxyde transparent conducteur comportant du zinc.

11. Procédé selon la revendication 10, dans lequel la gravure est mise en oeuvre en plongeant la cellule (100) dans un bain d'acide chlorhydrique dilué par de l'eau distillée avec un facteur de dilution compris entre 500 et 1000, pendant une durée comprise entre 25 secondes et 60 secondes.

12. Procédé selon l'une des revendications 10 ou 11, comportant en outre, après la gravure, un dépôt d'un matériau antireflet (128), avantageusement du SiO_{X}N_{Y}:H, recouvrant les contacts électriques (122) de face avant et les deuxièmes régions (126) de la première couche de semi-conducteur sélective de charge (112).

13. Procédé selon l'une des revendications 10 à 12, comportant en outre, entre la réalisation des contacts électriques (118, 122) et la gravure, la mise en oeuvre d'un recuit sous atmosphère de N₂, à une température comprise entre 200°C et 400°C et pendant une durée comprise entre 2 minutes à 10 minutes.

14. Procédé selon l'une des revendications 10 à 13, dans lequel :
- la cellule photovoltaïque (100) réalisée est une cellule photovoltaïque tandem ;
- le substrat (102), les première et deuxième couches de passivation (108, 110), et les première et deuxième couches de semi-conducteur sélectives de charge (112, 114) forment une première sous-cellule (132) de la cellule photovoltaïque (100) ;
et comportant en outre, entre la réalisation des contacts électriques (118, 122) et la gravure, la réalisation d'une deuxième sous-cellule (134) disposée entre la première couche d'oxyde d'indium (116) et la première sous-cellule (132).
